# EUROPEAN PATENT APPLICATION

(11) **EP 4 766 147 A2**
(43) Date of publication of application: **24.06.2026**
(21) Application number: 25219526.8
(22) Date of filing: 28.11.2025
(51) Int. Cl.: H10W 74/01, H10W 70/40, H10W 74/10, H10W 90/00

(54) **A SEMICONDUCTOR ASSEMBLY AND A METHOD OF MANUFACTURING THE SEMICONDUCTOR ASSEMBLY**

(30) Priority: 28.11.2024 MY PI2024006853
(71) Applicant: Nexperia B.V., 6534 AB Nijmegen (NL)
(72) Inventor: Kow, Siew Ting, Seremban (MY); Ooi, Choo Tian, Seremban (MY); Abdul Aziz, Aswafi Bin, Seremban (MY)
(74) Representative: Pjanovic, Ilija

(57) **Abstract**

The object of the present disclosure is to provide semiconductor assembly allowing to avoid cutting of the lead frame while separating the adjacent semiconductor assemblies, and allowing to perform sawing of the assemblies before trimming off the leads, for small packages. According to the first aspect, the object of the present disclosure has been achieved by providing a semiconductor assembly comprising a semiconductor die held in an encapsulant, wherein the encapsulant has a top part and a bottom part with leads extending out of the two opposite sides of the bottom part, wherein the bottom part of the encapsulant has a smaller width than the top part of the encapsulant, when measured along the lead bearing surfaces of the encapsulant. Providing a bottom part narrower than the top part allows for partial package sawing, where only the top part of the encapsulant is cut and cutting of the lead frame is avoided.

## Description

### TECHNICAL FIELD

The present disclosure relates to a semiconductor assembly and a method of manufacturing semiconductor assemblies. In particular, this disclosure relates to leaded semiconductor packages and an associated method of manufacturing such devices.

### BACKGROUND OF THE DISCLOSURE

Semiconductor assemblies, such as transistors, are manufactured as layered assemblies including components such as semiconductor dies, die paddles, leads and an encapsulant. Typical semiconductor devices comprise a semiconductor die attached to a lead frame and are encapsulated to form a packaged semiconductor device. A lead frame is a metal frame made of metal such as copper or its alloys that holds the die and provides the conductive path between the die and external circuits. The assembly further comprises bonding pads electrically connected to the leads of the lead frame with bond wires, whereby the bond wires are thin wires, often made of gold or copper. Leads are metal pins that extend from the semiconductor die to the exterior of the package for connection to a printed circuit board (PCB). Before singulation the leads are connected to the lead frame. After singulation the leads are bent or shaped in various configurations to facilitate mounting on a PCB, and serve as electrical connection between the die and the external circuits. The semiconductor assembly is encapsulated with a mould compound, typically plastic or epoxy resin, at least partially surrounding the semiconductor die. The encapsulant protects the semiconductor die and other components forming part of the semiconductor assembly from environmental and physical damage. The encapsulant may otherwise be referred to as a casing or housing. The resulting IC package can then be mounted onto a PCB and/or connected to other electrical components.

A leaded semiconductor package is thus a type of packaging that houses and protects a semiconductor device (such as an integrated circuit or IC) and provides electrical connections to external circuits through extending metal leads (pins). These packages are widely used in electronic devices due to their reliability and ease of use in automated assembly processes like printed circuit board (PCB) soldering.

The process of manufacturing semiconductor assemblies generally involves creating semiconductor dies using lithography, followed by attaching these semiconductor dies to die paddles. The die paddles are formed as an array that extends from a lead frame. After the dies are attached to the die paddles, leads are provided on an opposite side of the dies from the die paddles. An encapsulant is then applied over each die and the other components. The encapsulant may be manufactured through bar moulding. Parts of the die paddle and parts of the leads may extend beyond the encapsulant. The semiconductor die, other components and encapsulant is known as a semiconductor assembly. The assemblies are formed in an array, whereby each assembly is attached to the lead frame. The final step is to separate the semiconductor assemblies from the lead frame, in a process which may be referred to as singulation.

Singulation refers to the process of separating individual packaged devices from the lead frame for final testing and shipment. This method is critical for high-volume production. There are several singulation techniques, including saw singulation, laser singulation, punching or etching. Saw singulation is one of the most common methods for singulating leaded packages. In this method a precision diamond saw blade cuts along the predefined lines to separate individual units. It provides precise cuts and can handle a wide range of materials. Laser singulation uses a high-power laser to cut through the material and separate the individual packages. In punching method, a punch-and-die set is used to press and cut the individual packages out of the lead frame. Etching includes a chemical etchant to remove material between the devices to separate them.

Bar moulding is a packaging technique used in semiconductor manufacturing, particularly for encapsulating multiple semiconductor devices at once. It involves the use of a single mould to create a protective encapsulation (typically using a plastic or epoxy compound) around an entire array of semiconductor components that are connected on a lead frame. In this process, the lead frame with multiple dies attached and wire-bonded, is placed into a bar-shaped mould cavity. The mould is designed to encapsulate the entire array of semiconductor units at once, creating a continuous bar of encapsulated devices. Thus, multiple semiconductor devices are encapsulated simultaneously in a strip or bar format before individual singulation.

In known designs, the mould tool is designed with two layers which is top and bottom mould cavity, and the mould parting line is designed based on the lead frame thickness as mould clamping purpose. The resulting semiconductor packages thus have a casing (encapsulant) composed of a top part and a bottom part, whereby the bottom part is the part at the I/O side of the package. The bottom part of the casing surrounds and at least partially encapsulates the die, and the leads extend from the semiconductor die in this bottom part of the casing. The top and bottom cavity of the mould, and therefore the top part and the bottom part of the package, are designed with same width in the known bar concept manufacturing process. In the known semiconductor packages, the top part and the bottom part of the package, from the side having leads extending from it (which can be referred to as lead bearing side), have the same width. In view from the side with non-leads extending from it (which can be referred to as non-lead bearing side), the top part and the bottom part have tapered edges (the lead bearing surfaces are inclined toward the interior of the package).

The bottom parts of the packages (at the I/O side), which encapsulate the dies and have the leads extending from it, are adjacent to and in contact with each other. In other words, the top and bottom parts of one package are joined with the corresponding top and bottom parts of the adjacent package. During the sawing process, typically performed after trimming off the leads, in order to singulate the packages, the jig saw cuts through the entire package thickness, starting from the top surface of the top part of the casing. Simultaneously, to fully cut through the bottom part of the casing, the saw must also cut through the lead frame and lead frame tie bars (the tie bars are used to keep the lead frame intact and provide mechanical stability).

Known packages manufactured using bar concept, using conventional mould for encapsulation, are thus designed as square blocks, forming flat surface when they are joined in a bar before singulation. The packages become loose, separate units after performing package sawing process, as it involves cutting through the metallic material of the lead frame. Therefore, the process flow requires performing trimming and forming (TnF) first, to trim off the leads before package saw singulation can be carried out. Furthermore, the TnF step must be completed before sawing, because the jig saw is unable to handle packages smaller than 2 mm x 2 mm due to the suction cup's limitations - in the known solutions the package has to be held by vacuum suction pad or chuck table after sawing, which is not possible for packages smaller than 2 mm x 2 mm. As a result, current market design is not able to perform the process flow where package sawing is performed first, followed by the TnF step.

To sum up the above, during the sawing process, as the lead frame and lead frame's tie bars are cut through, the packages are no longer attached to the lead frame after sawing. Additionally, the package sawing process is time-consuming because the saw must cut through the entire thickness of the package and through at least part of the metallic material of the lead frame and lead frame's tie bar.

Document US8329509B2 discloses a method and apparatus for fabricating a low-pin-count chip package including a die pad and a plurality of leads having recessed lead ends at the outer peripheral region of each contact lead. After forming the package body over the integrated circuit device, unplated portions of the exposed bottom surface of the selectively plated lead frame are partially etched to form recessed lead ends at the outer peripheral region of each contact lead, and the recessed lead ends are subsequently re-plated to provide wettable recessed lead ends at the outer peripheral region of each contact lead. This method thus involves the step of etching of the leads and, by singulating the individual packaged devices with a saw that is applied along the singulation areas, aims to obtain each packaged device formed with recessed wettable lead flanks that provide increased solderable area, thereby increasing the overall solder joint strength and reliability while maintaining the quality and efficiency of sawn lead frame packaging processes.

Document US2021225744A1 discloses a package comprising a carrier, an electronic component on the carrier, an encapsulant encapsulating at least part of the carrier and the electronic component; and at least one lead having a punched surface, wherein at least part of at least one side flank of the encapsulant has a sawn texture and preferably also a recess not formed by sawing, but for example by punching. This allows sawing of side flank(s) to be carried out only through encapsulant material. Although this method allows to avoid cutting through the metallic material, it still requires sawing through the whole encapsulant material and comprises many method steps to obtain the sawn texture and recesses, which significantly extends the manufacturing process.

There is a need to address the disadvantages associated with existing semiconductor assemblies and associated methods of manufacture, whether mentioned in this document or otherwise.

### SUMMARY OF THE DISCLOSURE

Accordingly, an object of the present disclosure is to provide semiconductor assemblies that remain connected to the lead frame after the sawing process, thereby facilitating easier handling of the assemblies. Another objective of the disclosure is to reduce the duration of the package sawing process and to enable both process flows: one where package sawing is performed first, followed trimming off the leads, and another where the trimming off the leads is performed first, followed by package sawing.

According to the first aspect, the object of the present disclosure has been achieved by providing a semiconductor assembly comprising a semiconductor die held in an encapsulant, wherein the encapsulant has a top part and a bottom part with leads extending out of the two opposite sides of the bottom part, where the non-lead bearing surface of the encapsulant has an upper portion of the top part and a lower portion of the bottom part, and the lead bearing surface of the encapsulant has an upper portion of the top part and a lower portion of the bottom part,
wherein the bottom part has a smaller width than the top part of the encapsulant, along the lead bearing surfaces of the encapsulant.
Providing a bottom part narrower than the top part allows for partial package sawing, where only the top part of the encapsulant is cut and cutting of the lead frame is avoided. This feature further allows to perform sawing of the assemblies, which are smaller than 2mm x 2mm, before trimming off the leads.

Preferably, the lower portions of the non-lead bearing surfaces of the bottom part are tapered inwardly toward the lower surface of this bottom part.

Preferably, the lower portions of the lead bearing surfaces of the bottom part are tapered inwardly toward the lower surface of this bottom part.

Alternatively, the lower portions of the lead bearing surfaces of the bottom part form a flat lead bearing surfaces with upper portions of the lead bearing surface of the top part. This feature is applicable to one-sided packages, where the package is moulded using single-sided mould cavity.

Preferably, the upper portions of the lead bearing surfaces of the top part are tapered inwardly toward the upper surface of this top part.

Preferably, the top part of the encapsulant has a longitudinal indentation arranged at its bottom edge facing the bottom part and extending along each upper portion of the non-lead bearing surfaces. This allows to avoid accidental cutting of the lead frame while sawing and thus to avoid the damage of the saw and of the lead frame.

Preferably, the indentation has a shape of a section of a circle.

Alternatively, the indentation is formed as a bevelled edge of the top part.

According to the second aspect of the disclosure, there is provided a method of manufacturing semiconductor assemblies, comprising:
providing a lead frame with semiconductor dies attached;
applying encapsulant over each semiconductor die using a mould to form arrays of semiconductor assemblies, wherein the encapsulant has a top part and a bottom part from which the leads extend, and wherein the bottom part has a smaller width than the top part of the encapsulant along the lead bearing surfaces of the encapsulant;
sawing the semiconductor assemblies from the side of the top parts of the semiconductor assemblies, thereby separating the top parts of the adjacent semiconductor assemblies;
trimming off the leads to separate the semiconductor assemblies from the lead frame. This method allows to perform trimming off the leads before sawing the semiconductor assemblies for packages smaller than 2mm x 2mm as well as for the packages bigger than 2mm x 2mm.

Preferably, after trimming off the leads, the step of forming the leads is carried out. Forming allows to bend or shape the leads into their final configuration so they can be properly mounted onto a PCB.

According to the second aspect of the disclosure, there is provided another method of manufacturing semiconductor assemblies, comprising:
providing a lead frame with semiconductor dies attached;
applying encapsulant over each semiconductor die using a mould to form arrays of semiconductor assemblies, wherein the encapsulant has a top part and a bottom part from which the leads extend, and wherein the bottom part has a smaller width than the top part of the encapsulant along the lead bearing surfaces of the encapsulant;
trimming off the leads to separate the arrays of semiconductor assemblies from the lead frame;
sawing the semiconductor assemblies from the side of the top parts of the semiconductor assemblies, thereby separating the top parts of the adjacent semiconductor assemblies.

Preferably, after trimming off the leads, the step of forming the leads is carried out.

According to the third aspect of the disclosure, there is provided a mould for applying encapsulant over a semiconductor die, comprising a matrix of multiple mould cavities arranged in arrays, wherein the mould has a top layer of top mould cavities and a bottom layer of bottom mould cavities for encapsulating the leads, and wherein each bottom mould cavity has smaller width, in the direction parallel to the arrays of the mould cavities, than each corresponding top mould cavity.

The optional and/or preferred features of each aspect of the disclosure as set out herein are also applicable to any other aspects of the disclosure where appropriate.

### BRIEF DESCRIPTION OF THE DRAWINGS

The present disclosure will now be discussed, by way of example only, with reference to the accompanying drawings in which:
Figures 1A, 1B and 1C show a semiconductor assembly according to the prior art, in perspective view, in side view from the lead-bearing side and in side view from the non-lead-bearing side, respectively;
Figure 2 shows a perspective view of semiconductor assemblies according to the prior art, attached to a lead frame and forming parallelly arranged bars;
Figures 3A, 3B and 3C show a first embodiment of a semiconductor assembly according to the present disclosure, in perspective view, in side view from the lead-bearing side and in side view from the non-lead-bearing side, respectively;
Figure 4 shows a perspective view of semiconductor assemblies according to the first example of the present disclosure, attached to a lead frame and forming parallelly arranged bars;
Figure 5 shows a side view of two semiconductors assemblies according to the first example of the present disclosure, from the lead-bearing side, being cut by a saw on parting line;
Figures 6A, 6B and 6C show a second embodiment of a semiconductor assembly according to the present disclosure, in perspective view, in side view from the lead-bearing side and in side view from the non-lead-bearing side, respectively;
Figure 7 shows a side view of two semiconductors assemblies according to the second example of the present disclosure, from the lead-bearing side, being cut by a saw on parting line;
Figures 8A, 8B and 8C show a third embodiment of the semiconductor assembly according to the present disclosure, in perspective view, in side view from the lead-bearing side and in side view from the non-lead-bearing side, respectively;
Figure 9 shows a side view of two semiconductors assemblies according to the third example of the present disclosure, from the lead-bearing side, being cut by a saw on parting line;
Figure 10 shows the package manufacturing and sawing process where the process flow includes package sawing performed before the TnF step,
Figure 11 shows the package manufacturing and sawing process where the process flow includes TnF step performed before package sawing.

### DETAILED DESCRIPTION OF THE DISCLOSURE

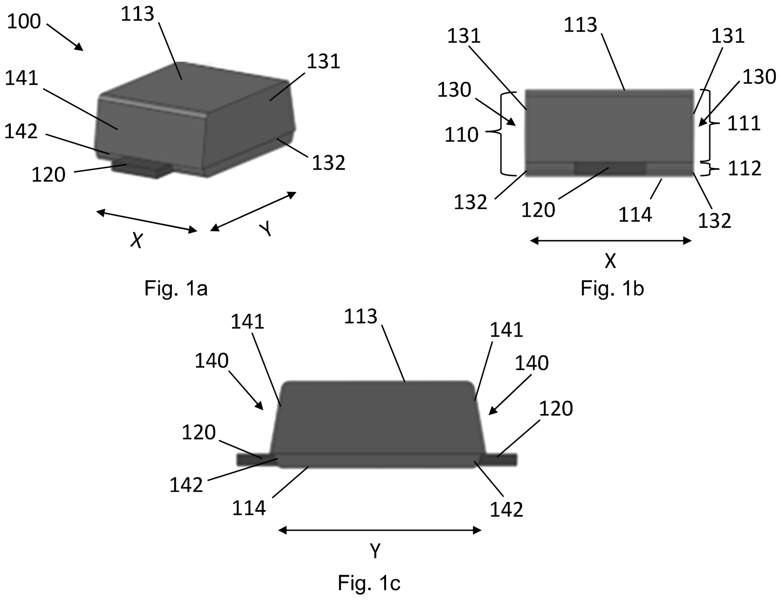

Figures 1A, 1B and 1C depict a semiconductor assembly known from the state of the art. Figure 1A depicts the semiconductor assembly 100 in perspective view. Figure 1B depicts the semiconductor assembly viewed from one end (X side view), from the lead bearing side. Figure 1C depicts the semiconductor assembly viewed from another end (Y side view), from the non-lead bearing side. The semiconductor assembly 100 comprises an encapsulant 110 from which leads 120 extend. Other parts of the semiconductor assembly such as the die are not visible.

Referring to Figure 1B, the encapsulant 110 includes a top part 111 and a bottom part 112. As depicted in Figures 1A, 1B and 1C, the encapsulant 110 has non-lead bearing surfaces 130 and lead bearing surfaces 140. Figure 1B provides a clear view of a shape of non-lead bearing surfaces 130 of the encapsulant 110 (i.e. the sides from which leads 120 do not extend). Figure 1C provides a view of a shape of lead bearing surfaces 140 of the encapsulant 110 (i.e. the sides from which leads 120 extend).

The upper surface 113 of the top part 111 of the encapsulant 110 is flat. The bottom part 112 of the encapsulant 110 is the part encapsulating the leads 120, from which these leads 120 extend. Both top part 111 and bottom part 112 of the encapsulant 110 have the same width throughout the whole thickness of the package when measured along the lead bearing surfaces 140, as depicted in Fig. 1B. For the sake of clarity, the non-bearing surface 130 of the encapsulant 110 is referred to as having an upper portion 131 (of the top part 111) and a lower portion 132 (of the bottom part 112). The upper portions 131 and the lower portions 132 of the non-lead bearing surfaces 130 are vertical when the semiconductor assembly 100 is in the depicted orientation - together, they form a flat surface and are not inclined with respect to each other.

A lower surface 114 (at the I/O side) of the encapsulant 110 is flat and has a shape of a square or rectangle. At least a portion of lower surface of the leads 120 may remain exposed and not covered by the bottom part 112 of the encapsulant 110.

Referring to Figure 1C, the lead bearing surface 140 of the encapsulant 110 is referred to as having an upper portion 141 (of the top part 111) and a lower portion 142 (of the bottom part 112). The upper portions 141 taper inwardly toward the upper surface 113 of the encapsulant 110, and the lower portions 142 taper inwardly toward the lower surface 114 of the encapsulant 110.

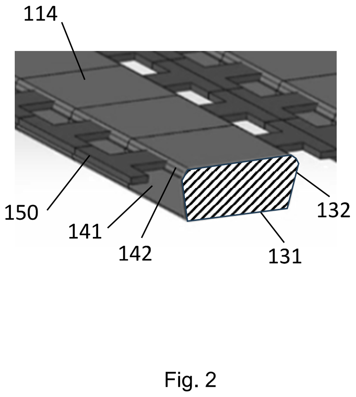

Figure 2 depicts a perspective view of semiconductor assemblies according to the prior art, which are attached to a lead frame 150. The assemblies are manufactured according to the bar moulding concept and thus form rows of bars (arrays) attached to the lead frame 150. The bars are formed by encapsulation using bar moulds in a known manner. Figure 2 provides a clear view of the shape of the lower (I/O) surfaces 114 of the known semiconductor assemblies. The lower surfaces 114 of the bottom parts 112 of each adjacent semiconductor assemblies 100 form a flat and smooth surface when connected to each other in a bar. **In** Figure 2, dashed lines depict the area of the non-lead bearing surface 130 which is cut by saw during the sawing process - as shown, both areas - upper portion 131 and lower portion 132 - are cut.

Such a prior art design implies that during the sawing process, to singulate the packages, the saw has to cut between top parts 111 and also between bottom parts 112 of the adjacent packages. Therefore, the saw also cuts through the metallic material of the lead frame 150 and lead frame's tie bar. An object of the present disclosure is thus to provide semiconductor assemblies which remain connected to the lead frame after sawing process. This has been achieved by providing a semiconductor assembly described below, referring to three exemplary examples.

According to the first aspect of the disclosure, there is provided a semiconductor assembly in which the encapsulant has a bottom part which is narrower than its top part, i.e. where the bottom part of the encapsulant has smaller width when measured along the lead bearing side. Such a design allows for partial package sawing, where only the top part of the encapsulant is cut. This also allows to improve the package sawing speed and prolongs blade life, since cutting of the metallic lead frame is avoided. Such a design further allows to perform the package sawing in strip form without trimming off the leads first. This reduces the risk of units falling out - package sawing may be performed when lead frame's tie bars are still attached to the packages.

Semiconductor assembly according to the present disclosure, in each example, comprises, in a known manner, a semiconductor die and other components of the semiconductor device, such as bond wires and bonding pads. As the semiconductor die is encapsulated in the encapsulant, it (as well as other components) is not visible in the attached Figures.

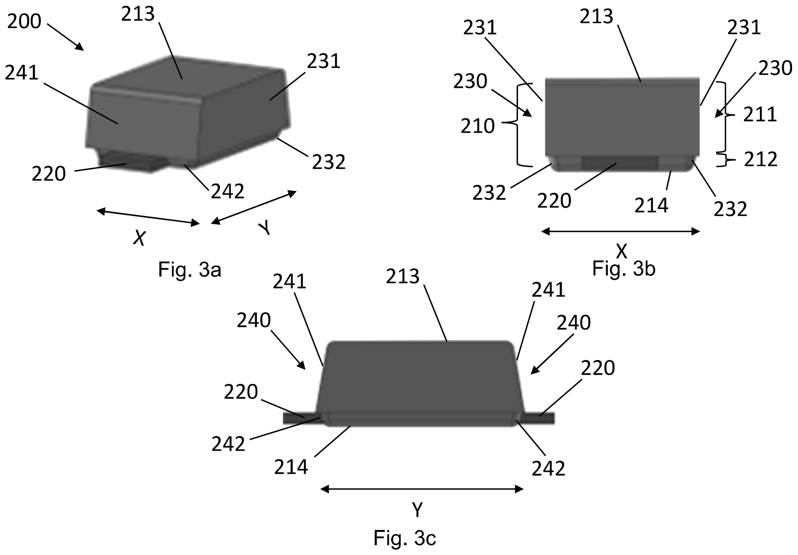

The first example of the semiconductor assembly according to the disclosure is depicted in Figures 3A, 3B and 3C. Figure 3A depicts the semiconductor assembly 200 in perspective view. Figure 3B depicts the semiconductor assembly 200 viewed from one end (X side view), from the lead bearing side. Figure 3C depicts the semiconductor assembly 200 viewed from another end (Y side view), from the non-lead bearing side. The semiconductor assembly 200 comprises an encapsulant 210 from which leads 220 extend. Other parts of the semiconductor assembly 200 such as the die are not visible.

Referring to Figure 3B, the encapsulant 210 includes a top part 211 and a bottom part 212. As depicted in Figures 3A, 3B and 3C, the encapsulant 210 has non-lead bearing surfaces 230 and lead bearing surfaces 240. Figure 3B provides a clear view of a shape of non-lead bearing surfaces 230 of the encapsulant 210 (i.e. the sides from which leads 220 do not extend). Figure 3C provides a view of a shape of lead bearing surfaces 240 of the encapsulant 210 (i.e. the sides from which leads 220 extend).

The upper surface 213 of the top part 211 of the encapsulant 210 is flat. The bottom part 212 of the encapsulant 210 is the part encapsulating the leads 220, from which these leads 220 extend. At least a portion of lower surface of the leads 220 may remain exposed and not covered by the bottom part 212 of the encapsulant 210.

Referring to Figure 3C, the lead bearing surface 240 of the encapsulant 210 is referred to as having an upper portion 241 (of the top part 211) and a lower portion 242 (of the bottom part 212). The upper portions 241 taper inwardly toward the upper surface 213 of the encapsulant 210, and the lower portions 242 taper inwardly toward the lower surface 214 of the encapsulant 210. However, since this feature does not affect the present disclosure, it is possible that the upper portions 241 and the lower portions 242 of the lead bearing surfaces 240 are arranged differently. For example, they may be vertical when the semiconductor assembly 200 is in the depicted orientation and may not be inclined with respect to each other. The shape of the lead bearing surface generally depends on the mould cavity design or package outline design.

Top part 211 and bottom part 212 of the encapsulant 210 have different widths when measured along the lead bearing surfaces 240, as depicted in Fig. 3B. For the sake of clarity, the non-lead bearing surface 230 of the encapsulant 210 is referred to as having an upper portion 231 (of the top part 211) and a lower portion 232 (of the bottom part 212).

The upper portions 231 of the non-lead bearing surfaces 230 are vertical when the semiconductor assembly 200 is in the depicted orientation. The lower portions 232 of the non-lead bearing surfaces 230 of the encapsulant 210 taper inwardly toward the lower surface 214 of the encapsulant 210. When measured along the lead bearing surface 240, the lower surface 214 (the I/O side) of the encapsulant 210, as well as the whole bottom part 212, has smaller width than the top part 211 (and obviously the upper portion 241 of the lead bearing surface 240) of the encapsulant 210. More precisely, the width of the bottom part 212 in the X direction measured at its portion closest to the top part 211 is smaller than the width of the top part 211 in the X direction, and the width of the bottom part 212 in the X direction measured near or at its lower surface 214 is smaller than the width of the bottom part 212 in the X direction at its portion closest to the top part 211. This is due to the inward tapering of the lower portions 232 of the non-lead bearing surfaces 230 of the bottom part 212.

In another variant of the first example (not depicted), the lower portions 232 of the non-lead bearing surfaces 230 of the bottom part 212 may not be inclined - this depends on the mould cavity design. Instead, for example, the lower portions 232 of the non-lead bearing surfaces 230 may be vertical, when the semiconductor assembly is the depicted orientation as depicted for example in Figure 3B. In this case the width of the bottom part 212 in the X direction (from the lead bearing side) is smaller than the width of the top part 211 measured in the same direction, but the lead bearing surface 242 of the bottom part 212 has the same width throughout its whole thickness, i.e. the same width near the top part 212 as well as at the lower surface 214. This is because the essence of the disclosure is to provide a space between the bottom parts of the encapsulant, allowing to separate the material of the packages only through cutting between the top parts of the encapsulant. Said lower portions 232 of the bottom part 212 may have any shape as long as a space between the bottom parts 212 of the adjacent encapsulants 210 is provided. The height of the bottom part 212 is basically the same as the thickness of the lead frame or the thickness of the tie bars, so that the lead frame can remain unsawn after singulation, what will be described in detail later below.

The difference between the width of the top part 211 (which may also be defined as the width of the upper portion 241 of the lead bearing surface 240) and the width of the bottom part 212 (which may also be defined as the width of the lower portion 242 of the lead bearing surface 242) measured near this top part 211, is for example 0,1 mm. In an example, the top part 211 has a width of 1,85 mm at its widest point, and the bottom part 212 has a width of 1,75 mm at its widest point.

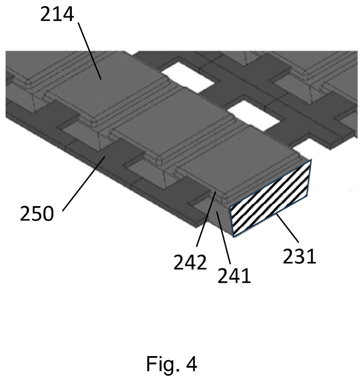

Figure 4 depicts a perspective view of semiconductor assemblies 200 according to the present disclosure, which are attached to a lead frame 250. The assemblies are manufactured according to the bar moulding concept and thus form rows of bars attached to the lead frame 250. The bars are formed by encapsulation using bar moulds with two layers which is top and bottom mould cavity, whereby the bottom cavity (arranged at the I/O side of the semiconductor device) has smaller width than the top cavity. Figure 4 provides a clear view of the shape of the lower (I/O) surfaces 214 of the semiconductor assemblies 200. As shown in Figure 4, the lower surfaces 214 of the bottom parts 212 of each adjacent semiconductor assemblies 200 form a surface resembling chocolate bar when connected to each other. The bottom parts 212 of the adjacent semiconductor assemblies 200 are thus separated from each other. In Figure 4, dashed lines depict the area of the non-lead bearing surface 230 which is cut by saw during the sawing process - as shown, only the area of the upper portion 231 is cut.

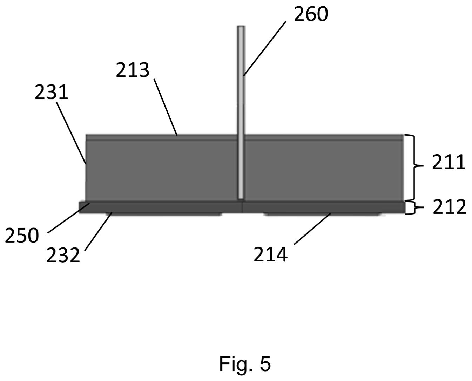

Figure 5 depicts a side view of two semiconductors assemblies 200 according to the first example of the present disclosure, from the lead-bearing side (X side), whereby the assemblies 300 are cut by a saw 260 on parting line. During the process of sawing, the saw 260 is inserted from the side of the upper surface 213 of the top part 211, cuts between the top parts 211 of the adjacent packages throughout the whole thickness of the top parts 211, and penetrates up to the bottom end of the top part 211. Thus, the saw 260 does not cut below the thickness of the top parts 211, thereby leaving the lead frame 250 uncut - the saw 260 does not cut though the lead frame 250 and is stopped above it. After the top parts 211 are separated, the packages remain held by the lead frame 250, but the encapsulants 210 are fully separated, since the bottom parts 212 are already separated due to their smaller width. In other words, the bottom parts 212 do not need to be cut since there already exists a space between them, due to the smaller width of the bottom parts 212. In effect, after cutting, the packages remain attached to the lead frame 250, and at the same time the encapsulants 210 of each adjacent packages are separated.

The first example of the present disclosure allows to avoid cutting through the metallic material of the lead frame, and thus the semiconductor assemblies remain connected to the lead frame after sawing process. However, since the top part 211 of the encapsulant 200 ends at the level at which the lead frame 250 is located, to fully cut through the top part 211, the saw 260 has to get close to the lead frame 250, and therefore there occurs a risk of touching the lead frame 250 by the saw 260 and thus damaging the saw 260 or the lead frame 250. In other words, in the arrangement according to the first example, during sawing process the saw 260 may touch and damage the lead frame 250, because to cut through the whole top part 211, the saw 260 needs to get close to the lead frame.

Therefore there is a need to prevent the saw from accidental cutting on lead frame and lead frame's tie bars. This is achieved by providing the semiconductor assembly according to the second embodiment of the disclosure.

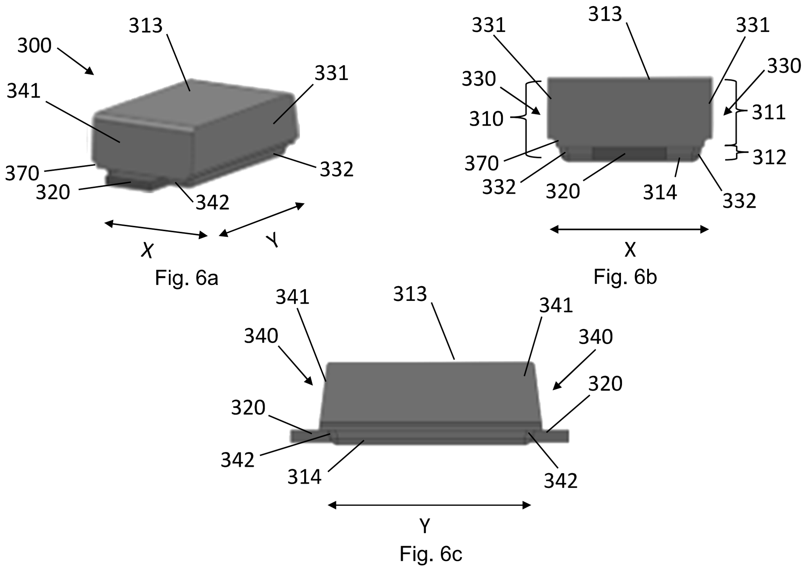

The second example of the semiconductor assembly according to the disclosure is depicted in Figures 6A, 6B and 6C. Figure 6A depicts the semiconductor assembly 300 in perspective view. Figure 6B depicts the semiconductor assembly 300 viewed from one end (X side view), from the lead bearing side. Figure 6C depicts the semiconductor assembly 300 viewed from another end (Y side view), from the non-lead bearing side. The semiconductor assembly 300 comprises an encapsulant 310 from which leads 320 extend. Other parts of the semiconductor assembly 300 such as the die are not visible.

Referring to Figure 6B, the encapsulant 310 includes a top part 311 and a bottom part 312. As depicted in Figures 6A, 6B and 6C, the encapsulant 310 has non-lead bearing surfaces 330 and lead bearing surfaces 340. Figure 6B provides a clear view of a shape of non-lead bearing surfaces 330 of the encapsulant 310 (i.e. the sides from which leads 320 do not extend). Figure 6C provides a view of a shape of lead bearing surfaces 340 of the encapsulant 310 (i.e. the sides from which leads 320 extend).

The upper surface 313 of the top part 311 of the encapsulant 310 is flat. The bottom part 312 of the encapsulant 310 is the part encapsulating the leads 320, from which these leads 320 extend. At least a portion of lower surface of the leads 320 may remain exposed and not covered by the bottom part 312 of the encapsulant 310.

Referring to Figure 6C, the lead bearing surface 340 of the encapsulant 310, similarly as in the first example, has an upper portion 341 (of the top part 311) and a lower portion 342 (of the bottom part 312). The upper portions 341 taper inwardly toward the upper surface 313 of the encapsulant 310, and the lower portions 342 taper inwardly toward the lower surface 314 of the encapsulant 310. However, as in the first example, the upper portions 341 and the lower portions 342 of the lead bearing surfaces 340 may be arranged differently. For example, they may be vertical when the semiconductor assembly 300 is in the depicted orientation and may not be inclined with respect to each other. This depends on the mould cavity design or package outline design.

Top part 311 and bottom part 312 of the encapsulant 310 have different widths when measured along the lead bearing surfaces 340 (X direction), as depicted in Fig. 6B. The non-bearing surface 330 of the encapsulant 310 is referred to as having an upper portion 331 (of the top part 311) and a lower portion 332 (of the bottom part 312).

The upper portions 331 of the non-lead bearing surfaces 330 are vertical when the semiconductor assembly 300 is in the depicted orientation. The lower portions 332 of the non-lead bearing surfaces 330 of the encapsulant 310 taper inwardly toward the lower surface 314 of the encapsulant 310. When measured along the lead bearing surface 340, the lower surface 314 of the encapsulant 310, as well as the whole bottom part 312, has smaller width than the top part 311 (and obviously the upper portion 341 of the lead bearing surface 340) of the encapsulant 310. More precisely, the width of the bottom part 312 in the X direction measured at its portion closest to the top part 311 is smaller than the width of the top part 311 in the same direction, and the width of the bottom part 312 in the X direction measured near or at its lower surface 314 is smaller than the width of the bottom part 312 in the X direction measured at its portion closest to the top part 311. This is due to the inward tapering of the lower portions 332 of the non-lead bearing surfaces 330 of the bottom part 312.

In another variant of the second example (not depicted), the lower portions 332 of the non-lead bearing surface 330 of the bottom part 312 may not be tapered and instead for example may be vertical, similarly as described in the first example. In this case the width of the bottom part 312 in the X direction measured at any location (horizontally) is smaller than the width of the top part 311 measured in the same direction. Said lower portions 332 of the bottom part 312 may have any shape as long as a space between the bottom parts 312 of the adjacent encapsulants 310 is provided. The height of the bottom part 312 is basically the same as the thickness of the lead frame or the thickness of the tie bars, so that the lead frame can remain unsawn after singulation.

Although the bottom part 312 of the encapsulant 310 is shaped as in the first example, the top part 311 has an additional feature allowing to avoid accidental cutting of the lead frame by the saw.

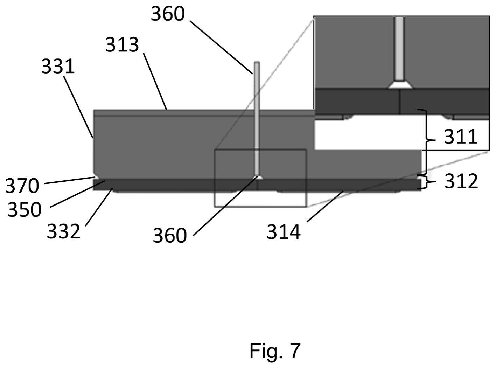

As shown clearly in Figure 6B and in Figure 7, the top part 311 of the encapsulant 310 at its bottom side, which is the side facing the bottom part 312, has a longitudinal indentation 370. The indentation 370 is provided along each upper portion 331 of the non-lead bearing surfaces 330, and is located at the bottom side of the top part 311. In other words, the indentation 370 extends along the bottom edge of the upper portion 331 the non-lead bearing surface 330. Therefore, from the lead bearing side (depicted in Figure 6B), the upper portion 331 of the lead bearing surface 330 has a cut-out in the form of longitudinal indentation 370.

The indentation 370 may for example have a shape of a section of a circle, as depicted in Figures 6A, 6B and 6C, or may be straight and thus be formed as a bevelled edge of the top part 311, tapering toward the bottom part 312 of the encapsulant 310, as depicted in Figure 7. In the latter case, the upper portion 331 of the non-lead bearing surface 330 is chamfered at its bottom edge.

The difference between the width of the top part 311 (which may also be defined as the width of the upper portion 341 of the lead bearing surface 340) measured at the upper surface 313 and the width of the top part 311 measured at its bottom surface, i.e. near the bottom part 312, is for example from... to...

The difference between the width of the top part 311 measured near or at its upper surface 313, and the width of the bottom part 312 near this top part 311, is for example 0,1 mm. In an example, the top part 311 has a width of 1,85 mm at its widest point, and the bottom part 312 has a width of 1,75 mm at its widest point.

Semiconductor assemblies 300 according to the second example of the present disclosure, when attached to the lead frame to form rows of bars attached to the lead frame, from the I/O side look identically as in the perspective view depicted in the Figure 4, described with reference to the first example, and thus the description of such an arrangement is not repeated with regard to the second example.

Figure 7 depicts a side view of two semiconductors assemblies 300 according to the second example of the present disclosure, from the lead bearing side (X side), whereby the assemblies 300 are cut by a saw 360 on parting line. During the process of sawing, the saw 360 is inserted from the side of the upper surface 313 of the top part 311, cuts between the top parts 311 of the adjacent packages throughout the whole thickness of the top parts 311 and penetrates up to the beginning of the indentation 370 (i.e. cuts through the flat surface of the upper portion 331). Thus, the saw 360 does not cut below this top part 311, thereby leaving the lead frame 350 uncut - the saw 360 does not cut though the lead frame 350 and is stopped above it. After the top parts 311 are separated, the packages remain held by the lead frame 350, but the encapsulant 310 is fully separated, since the bottom parts 312 are already separated due to their smaller width. In other words, the bottom parts 312 need not be cut through since there already exists a space between them, due to the smaller width of the bottom parts 312. In effect, after cutting, the packages remain attached to the lead frame 350, and at the same time the encapsulants 310 of each adjacent packages are separated.

In contrast to the first example, the saw 360 does not have to fully cut through the top part 311, because for adjacent semiconductor assemblies 300, the portions of the top parts' 311 surfaces located next to the bottom part 312 are already separated by the indentations 370. In other words, as clearly depicted in Figure 7, the indentations 370 of the adjacent packages 300 form a gap between the upper portions 331 of the non-lead bearing surfaces 330. In other words, below the sawing line where the saw 360 is introduced, there is provided an interspace between the horizontal plane at which the upper edge of the indentation 370 is located and the horizontal plane at which the lead frame 350 is located. To fully separate the top parts 311 of the adjacent semiconductor assemblies 300, it is sufficient to saw up to the beginning of the indentation 370.

Therefore, the second example of the disclosure allows to eliminate the risk of touching the lead frame 350 by the saw 360 and thus damaging the saw 360 or the lead frame 350. In other words, in the arrangement according to the second example, during sawing process the saw 360 is prevented from touching the lead frame 350, since it does not need to get close to the lead frame 350 to fully separate the adjacent encapsulants 310.

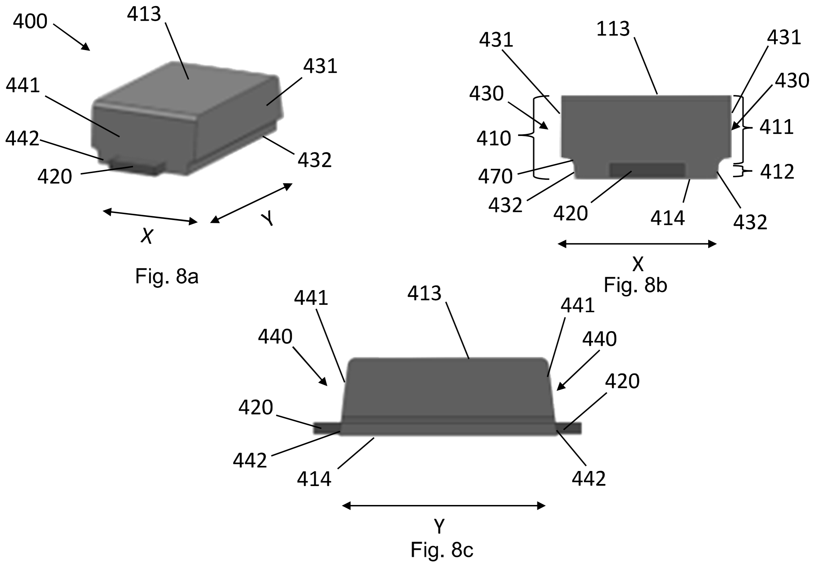

The third example of the semiconductor assembly according to the disclosure is depicted in Figures 8A, 8B and 8C. Figure 8A depicts the semiconductor assembly 400 in perspective view. Figure 8B depicts the semiconductor assembly 400 viewed from one end (X side view), from the lead bearing side. Figure 8C depicts the semiconductor assembly 400 viewed from another end (Y side view), from the non-lead bearing side. The semiconductor assembly 400 comprises an encapsulant 410 from which leads 420 extend. Other parts of the semiconductor assembly 400 such as the die are not visible.

Referring to Figure 8B, the encapsulant 410 includes a top part 411 and a bottom part 412. As depicted in Figures 8A, 8B and 8C, the encapsulant 410 has non-lead bearing surfaces 430 and lead bearing surfaces 440. Figure 8B provides a clear view of a shape of non-lead bearing surfaces 430 of the encapsulant 410 (i.e. the sides from which leads 420 do not extend). Figure 8C provides a view of a shape of lead bearing surfaces 440 of the encapsulant 410 (i.e. the sides from which leads 420 extend).

The upper surface 413 of the top part 411 of the encapsulant 410 is flat. The bottom part 412 of the encapsulant 410 is the part encapsulating the leads 420, from which these leads 420 extend. At least a portion of lower surface of the leads 420 may remain exposed and not covered by the bottom part 412 of the encapsulant 410.

The semiconductor assembly according to the third example is applicable to one-sided semiconductor assemblies, such as heatsink packages. Such package is manufactured by moulding using mould cavity being single sided mould cavity, i.e. using one layer of mould cavities.

Referring to Figure 8C, the lead bearing surface 440 of the encapsulant 410, similarly as in the previous examples, has an upper portion 441 (of the top part 411) and a lower portion 442 (of the bottom part 412). The upper portions 441 taper inwardly toward the upper surface 413 of the encapsulant 410. The lower portions 442 taper inwardly also toward the upper surface 413 of the encapsulant 410. Thus, the upper portion 441 of the lead bearing surface 440 and the lower portion 442 of the lead bearing surface 440 form together a substantially flat surface. The encapsulant 410 is therefore widest at the lower surface 414 and narrowest at the upper surface 413 - the lead bearing side is tapered, starting from the bottom of the lower surface 414, inwardly toward the upper surface 413. However, as in the previous examples, the upper portions 441 and the lower portions 442 of the lead bearing surfaces 440 may be arranged differently and for example may be vertical. This depends on the design of the mould cavity.

Top part 411 and bottom part 412 of the encapsulant 410 have different widths when measured along the lead bearing surfaces 440 (X direction), as depicted in Fig. 8B. The non-bearing surface 430 of the encapsulant 410 has an upper portion 431 (of the top part 411) and a lower portion 432 (of the bottom part 412).

The upper portions 431 of the non-lead bearing surfaces 430 are vertical when the semiconductor assembly 400 is in the depicted orientation. The lower portions 432 of the non-lead bearing surfaces 430 of the encapsulant 410 are vertical or taper inwardly toward the lower surface 414 of the encapsulant 410. When measured along the lead bearing surface 440, the lower surface 414 of the encapsulant 410, as well as the whole bottom part 412, has smaller width than the top part 411 (and obviously the upper portion 441 of the lead bearing surface 440) of the encapsulant 410. More precisely, the width of the bottom part 412 in the X direction is smaller than the width of the top part 411 in the same direction (measured near its top surface 413).

Said lower portions 432 of the bottom part 412 may have any shape as long as a space between the bottom parts 412 of the adjacent encapsulants 410 is provided.

The top part 411 of the semiconductor assembly 400 has an additional feature allowing to avoid accidental cutting of the lead frame by the saw, similarly as in the second example.

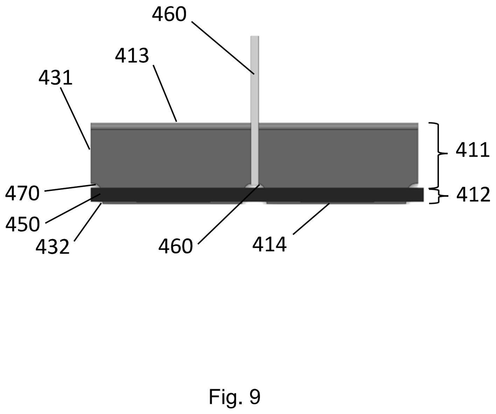

As shown clearly in Figure 8B and in Figure 9, the top part 411 of the encapsulant 410 at its bottom side, which is the side facing the bottom part 412, has a longitudinal indentation 470. The indentation 470 is provided along each upper portion 431 of the non-lead bearing surfaces 430, and is located at the bottom side of the top part 411. In other words, the indentation 470 extends along the bottom edge of the upper portion 431 the non-lead bearing surface 430. Therefore, from the lead bearing side 440 (depicted in Figure 8B), the upper portion 431 of the lead bearing surface 430 has a cut-out in the form of longitudinal indentation 470.

The indentation 370 may for example have a shape of a section of a circle, as depicted in Figures 8A, 8B and 8C, or may be straight and thus be formed as a bevelled edge of the top part 411, tapering toward the bottom part 412 of the encapsulant 410 (not shown). In the latter case, the upper portion 431 of the non-lead bearing surface 430 is chamfered at its bottom edge.

The difference between the width of the top part 411 (which may also be defined as the width of the upper portion 441 of the lead bearing surface 440) measured near or at its upper surface 413, and the width of the bottom part 412 near or at the lower surface 414, is for example 0,1 mm.

Semiconductor assemblies 400 according to the third example of the present disclosure, when attached to the lead frame to form rows of bars attached to the lead frame, from the I/O side look similar as in the perspective view depicted in the Figure 4, described with reference to the first example, and thus the description of such an arrangement is not repeated with regard to the second example. The difference is that the upper portion 441 of the lead bearing surface 440 and the lower portion 442 of the lead bearing surface 440 form together a flat and smooth surface, which may be inclined toward the upper surface 413 of the encapsulant 410.

Figure 9 depicts a side view of two semiconductors assemblies 400 according to the third example of the present disclosure, from the lead bearing side (X side), whereby the assemblies 400 are cut by a saw 460 on parting line. During the process of sawing, the saw 460 is inserted from the side of the upper surface 413 of the top part 411, cuts between the top parts 411 of the adjacent packages throughout the whole thickness of the top parts 411 and penetrates up to the beginning of the indentation 470 (i.e. cuts through the flat surface of the upper portion 431). Thus, similarly as in the second example, the saw 460 does not cut below this top part 411, thereby leaving the lead frame 450 uncut - the saw 460 does not cut though the lead frame 450 and is stopped above it. After the top parts 411 are separated, the packages remain held by the lead frame 450, but the encapsulant 410 is fully separated, since the bottom parts 412 are already separated due to their smaller width. In other words, the bottom parts 412 need not be cut through since there already exists a space between them, due to the smaller width of the bottom parts 412. In effect, after cutting, the packages remain attached to the lead frame 450, and at the same time the encapsulants 410 of each adjacent packages are separated.

In contrast to the first example, and similarly as in the second example, the saw 460 does not have to fully cut through the top part 411, because for adjacent semiconductor assemblies 400, the portions of the top parts' 411 surfaces located next to the bottom part 412 are already separated by the indentations 470. In other words, as clearly depicted in Figure 9, the indentations 470 of the adjacent packages 400 form a gap between the upper portions 431 of the non-lead bearing surfaces 430. In other words, below the sawing line where the saw 460 is introduced, there is provided an interspace between the horizontal plane at which the upper edge of the indentation 470 is located and the horizontal plane at which the lead frame 450 is located. To fully separate the top parts 411 of the adjacent semiconductor assemblies 400, it is sufficient to saw up to the beginning of the indentation 470.

Therefore, the third example of the disclosure also allows to eliminate the risk of touching the lead frame 450 by the saw 460 and thus damaging the saw 460 or the lead frame 450. In other words, during sawing process the saw 460 is prevented from touching the lead frame 450, since it does not need to get close to the lead frame 450 to fully separate the adjacent encapsulants 410.

To sum up, the essence of the disclosure is that the distance between the lower portions 232, 332, 432 of the non-lead bearing surfaces 230, 330, 430 of the bottom part 212, 312, 412 is smaller than the distance between the upper portions 231, 331, 431 of the non-lead bearing surfaces 230, 330, 430 of the top part 211, 311, 411.

The structure of semiconductor assembly according to the present disclosure is applicable to any type of this device - for example, the assembly may comprise different number of leads which extend from the lead bearing sides. More precisely, regardless of the example of the disclosure, one lead bearing side of the package may have two leads extending from the lower portion of the lead bearing surface, and the second lead bearing side of the package, opposite to the first lead bearing side of said package, may have one lead extending from the lower portion of the lead bearing surface.

The encapsulant 210, 310, 410 of the semiconductor assembly according to the disclosure may be made of any appropriate polymer material, such as any kind of epoxy mould compounds (EMC).

The encapsulant 210, 310, 410 are preferably manufactured by injection moulding. This allows the encapsulant 210, 310, 410 to be provided with desirable shape, such as proposed in the three examples described above, without incurring significant additional expense.

The indentations 370, 470 proposed in the second and third examples are also made by injection moulding - the mould used to encapsulate the semiconductor devices has appropriate shape allowing to manufacture such indentations 370, 470.

The proposed semiconductor assembly, according to any of the proposed examples, allows to carry out the manufacturing method in which both process flows are possible: one where package sawing is performed first, followed by the TnF step, and another where the TnF step is performed first, followed by package sawing.

The method of manufacturing and handling semiconductor assemblies is thus provided according to the second aspect of the disclosure.

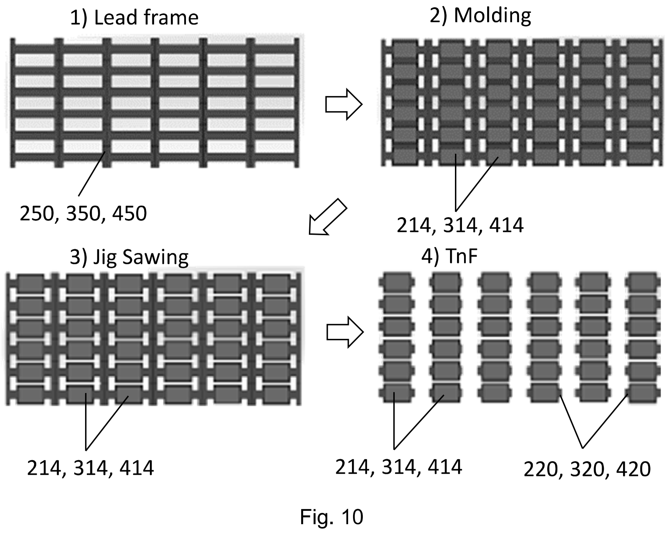

Figure 10 shows the package manufacturing and sawing process where the process flow includes package sawing performed before the TnF step, wherein the process is depicted in top view from the bottom (I/O) side 214, 314, 414 of the assemblies. The process of manufacturing semiconductor assemblies is depicted in Figure 10 schematically, where only the steps important from the view of the present disclosure are shown.

The process of manufacturing semiconductor assemblies generally involves creating semiconductor dies using lithography, followed by attaching these semiconductor dies to die paddles (not shown in Figure 10). After the dies are attached to the die paddles, leads are provided on an opposite side of the dies from the die paddles, by attaching the dies to the lead frame. The first process step depicted in Fig. 10 is thus providing a lead frame 250, 350, 240. By attaching the dies to the lead frame 250, 350, 450, the leads are provided on the opposite sides of the dies (not shown).

In the second step, an encapsulant 210, 310, 410 is applied over each die and the other components. The encapsulant 210, 310, 410 is manufactured through bar moulding, and has a form, for example, as described according to the first, second or third example. The shape of the encapsulant 210, 310, 410 is defined by the shape of the mould. For manufacturing the assembly 210, 310 according to second and third example, two-sided mould is used. For manufacturing the assembly 410 according to third example, one-sided mould is used. Parts of the die paddle and parts of the leads may extend beyond the encapsulant 210, 310, 410. The semiconductor die, other components and encapsulant 210, 310, 410 is known as a semiconductor assembly. The semiconductor assemblies 200, 300, 400 are formed in an array, whereby each assembly is attached to the lead frame 250, 350, 450. The array of the assemblies 200, 300, 400 resembles the shape of a chocolate bar.

In the third step, sawing of the semiconductor assemblies 200, 300, 400 is carried out, to separate the top parts 211, 311, 411 of the semiconductor assemblies 200, 300, 400. The saw is inserted from the side of the top parts 211, 311, 411 and is arranged along the sawing lines, parallelly to the leads 220, 320, 420. The saw does not cut through the lead frame 250, 350, 450. After sawing the top parts 211, 311, 411 of the semiconductor assemblies 200, 300, 400 and the bottom parts 212, 312, 412 of the semiconductor assemblies 200, 300, 400 are separated, whereby the top parts 211, 311, 411 are separated using a saw in sawing step, and the bottom parts 212, 312, 412 are already separated due to their smaller width (in the direction parallel to the lead bearing sides of the packages and to the arrays). As a result, the encapsulants 210, 310, 410 are separated, but the semiconductor assemblies 200, 300, 400 are still connected by the lead frame 250, 250, 450.

In the fourth step, trimming and forming (TnF) is carried out to singulate the semiconductor assemblies 200, 300, 400. In this step the lead frame 250, 350, 450 is cut and the leads 220, 230, 240 are trimmed off and formed, i.e. shaped for proper connection to a printed circuit board (PCB). Trimming refers to the cutting or removal of the excess metal (known as the tie bars) from the lead frame 250, 350, 450 that holds multiple semiconductor assemblies 200, 300, 400 together, to leave only the leads 220, 320, 420 that are necessary for external connections. Forming refers to bending or shaping the remaining metal leads 220, 320, 420 into their final configuration and thus is not a step necessary to singulate the packages according to the disclosure. Depending on the package type (e.g., DIP, SOIC), the leads 220, 320, 420 need to be bent or formed in specific angles and shapes so they can be properly mounted onto a PCB. After trimming and forming, each individual semiconductor assembly 200, 300, 400 is fully separated from the lead frame 250, 350, 450.

The speed of the saw used to cut the top parts 211, 311, 411 of the encapsulants 210, 310, 410 is for example from 300 to 800 mm/s, and the speed of the saw used to cut the metallic material is for example from 50 to 150 mm/s.

The process flow depicted in Figure 10 allows to avoid using the suction cup for holding individual packages, since the TnF step is carried out after sawing. As mentioned before, in the known solutions the package has to be held by vacuum suction pad or chuck table after sawing, which is not possible for packages smaller than 2 mm x 2 mm. By ensuring that the packages are held by the lead frame after sawing, the TnF step may be performed after the step of sawing. Therefore, the process flow depicted in Figure 10 is applicable to packages smaller than 2mm x 2mm, as well as to the packages bigger than 2mm x 2mm. This process flow also allows to increase the lead frame density by 30-100% with regard to known solutions, whereby the lead frame density refers to the number of leads (or pins) per unit area on a lead frame,

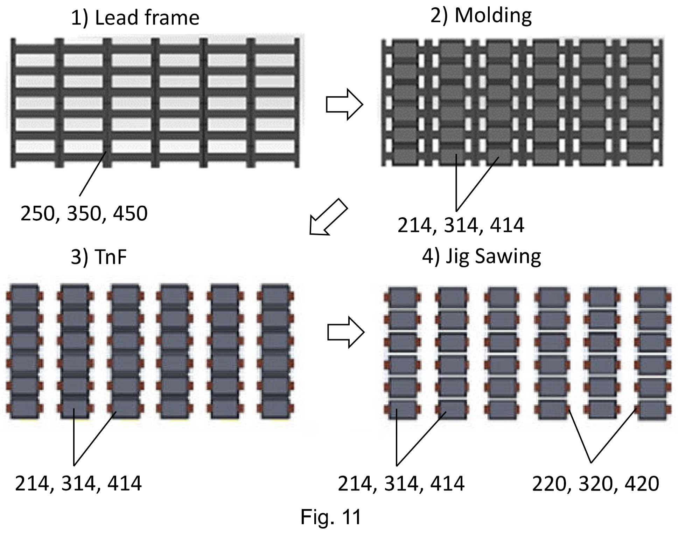

Figure 11 shows the package manufacturing and sawing process where the process flow includes TnF step performed before package sawing, wherein the process is depicted in top view from the bottom (I/O) side 214, 314, 414 of the assemblies. The process of manufacturing semiconductor assemblies is depicted in Figure 11 schematically, where only the steps important from the point of view of the present disclosure are shown.

The process of manufacturing semiconductor assemblies involves creating semiconductor dies using lithography, followed by attaching these semiconductor dies to die paddles (not shown in Figure 11), and providing the leads by attaching the dies to the lead frame, as described with reference to Figure 10. The first process step depicted in Fig. 11 is thus providing a lead frame 250, 350, 240 and attaching the dies (not shown) to the lead frame 250, 350, 450 to provide the leads.

In the second step, an encapsulant 210, 310, 410 is applied over each die and the other components, as described with reference to the second step depicted in Figure 10.

In the third step, trimming and forming (TnF) is carried out to separate the arrays of semiconductor assemblies 200, 300, 400. In this step the lead frame 250, 350, 450 is cut and the leads 220, 230, 240 are shaped for proper connection to a PCB. Trimming refers to the cutting or removal of the excess metal from the lead frame 250, 350, 450, to leave only the leads 220, 320, 420 that are necessary for external connections. Forming refers to bending or shaping the remaining metal leads 220, 320, 420 into their final configuration and thus is not a step necessary to singulate the packages according to the disclosure. Depending on the package type (e.g., DIP, SOIC), the leads 220, 320, 420 need to be bent or formed in specific angles and shapes so they can be properly mounted onto a PCB. After TnF, the semiconductor assemblies 200, 300, 400 are not fully separated from the lead frame 250, 350, 450, but remain arranged in arrays composed of adjacent semiconductor assemblies 200, 300, 400 connected by their top parts 211, 311, 411. The arrays are separated from the lead frame 250, 350, 450 after this step.

In the fourth step, sawing of the semiconductor assemblies 200, 300, 400 is carried out, to fully singulate the top parts 211, 311, 411 of the semiconductor assemblies 200, 300, 400. The saw is inserted from the side of the top parts 211, 311, 411 and is arranged along the sawing lines, parallelly to the leads 220, 320, 420. After sawing the top parts 211, 311, 411 of the semiconductor assemblies 200, 300, 400 and the bottom parts 212, 312, 412 of the semiconductor assemblies 200, 300, 400 are separated, whereby the top parts 211, 311, 411 are separated using a saw in sawing step, and the bottom parts 212, 312, 412 are already separated due to their smaller width. As a result, the semiconductor assemblies 200, 300, 400 are fully singulated.

The speed of the saw used to cut the top parts 211, 311, 411 of the encapsulants 210, 310, 410 is for example from 300 to 800 mm/s, and the speed of the saw used to cut the metallic material is for example from 50 to 150 mm/s.

The process flow depicted in Figure 11 is applicable to packages bigger than 2mm x 2mm. This process flow also allows to increase the lead frame density by ~30% with regard to known solutions.

According to the third aspect of the disclosure, there is provided a mould for encapsulation of the components of the semiconductor devices, allowing to obtain encapsulants 200, 300, 400 according to the disclosure.

The mould comprises a matrix of multiple bar-shaped mould cavities. In the first example, the mould has two layers, a top layer and a bottom layer, wherein the top layer comprises top mould cavities arranged in arrays, and the bottom layer comprises bottom mould cavities arranged in arrays. The bottom layer is intended for moulding the bottom (I/O) side of the semiconductor device. The mould parting line is designed based on the lead frame thickness as mould clamping purpose. This is applicable to two-sided packages 200, 300. In another example, the mould has one layer of mould cavities arranged in arrays. This is applicable to one-sided package 400.

The top and bottom mould cavities, or mould cavities in single layer, have a shape complementary to the intended and desired shape of the top part 211, 311, 411 and bottom part 212, 312, 412 of the encapsulant 200, 300, 400. The top and bottom cavity of the mould, or top and bottom side of one-layer mould, have thus different widths. More precisely, each bottom mould cavity (or bottom side of one-layer mould cavity) has smaller width, in the direction parallel to the arrays of the mould cavities, than each corresponding top mould cavity. The top mould cavities (or top side of one-layer mould cavity) may have a shape complementary to the indentation which is to be made in the top part 311, 411 of the encapsulant 300, 400, as described according to the second and third example.

### LIST OF REFERENCE NUMERALS USED

- 100, 200, 300, 400: semiconductor assembly
- 110, 210, 310, 410: encapsulant
- 111, 211, 311, 411: top part of the encapsulant
- 112, 212, 312, 412: bottom part of the encapsulant
- 113, 213, 313, 413: upper surface of the encapsulant
- 114, 214, 314, 414: lower surface of the encapsulant
- 120, 220, 320, 420: leads
- 130, 230, 330, 430: non-lead bearing surfaces
- 131, 231, 331, 431: upper portions of the non-lead bearing surfaces
- 132, 232, 332, 432: lower portions of the non-lead bearing surfaces
- 140, 240, 340, 440: lead bearing surfaces
- 141, 241, 341, 441: upper portions of the non-lead bearing surfaces
- 142, 242, 342, 442: lower portions of the non-lead bearing surfaces
- 150, 250, 350, 450: lead frame
- 260, 360, 460: saw
- 370, 470: indentation

## Claims

1. A semiconductor assembly comprising a semiconductor die held in an encapsulant, wherein the encapsulant has a top part and a bottom part with leads extending out of the two opposite sides of the bottom part, where the non-lead bearing surface of the encapsulant has an upper portion of the top part and a lower portion of the bottom part, and the lead bearing surface of the encapsulant has an upper portion of the top part and a lower portion of the bottom part,
wherein the bottom part has a smaller width than the top part of the encapsulant, along the lead bearing surfaces of the encapsulant.

2. The semiconductor assembly according to claim 1, wherein the lower portions of the non-lead bearing surfaces of the bottom part taper inwardly toward the lower surface of this bottom part.

3. The semiconductor assembly according to claim 1 or 2, wherein the lower portions of the lead bearing surfaces of the bottom part taper inwardly toward the lower surface of this bottom part.

4. The semiconductor assembly according to claim 1 or 2, wherein the lower portions of the lead bearing surfaces of the bottom part form a flat lead bearing surfaces with upper portions of the lead bearing surface of the top part.

5. The semiconductor assembly according to claim 1 or 2 or 3 or 4, wherein the upper portions of the lead bearing surfaces of the top part taper inwardly toward the upper surface of this top part.

6. The semiconductor assembly according to any of the preceding claims, wherein the top part of the encapsulant has a longitudinal indentation arranged at its bottom edge facing the bottom part and extending along each upper portion of the non-lead bearing surfaces.

7. The semiconductor assembly according to claim 6, wherein the indentation has a shape of a section of a circle.

8. The semiconductor assembly according to claim 6, wherein the indentation is formed as a bevelled edge of the top part.

9. A method of manufacturing semiconductor assemblies, comprising:
providing a lead frame with semiconductor dies attached;
applying encapsulant over each semiconductor die using a mould to form arrays of semiconductor assemblies, wherein the encapsulant has a top part and a bottom part from which the leads extend, and wherein the bottom part has a smaller width than the top part of the encapsulant along the lead bearing surfaces of the encapsulant;
sawing the semiconductor assemblies from the side of the top parts of the semiconductor assemblies, thereby separating the top parts of the adjacent semiconductor assemblies;
trimming off the leads to separate the semiconductor assemblies from the lead frame.

10. A method of manufacturing semiconductor assemblies according to claim 9, wherein after trimming off the leads, the step of forming the leads is carried out.

11. A method of manufacturing semiconductor assemblies, comprising: providing a lead frame with semiconductor dies attached;
applying encapsulant over each semiconductor die using a mould to form arrays of semiconductor assemblies, wherein the encapsulant has a top part and a bottom part from which the leads extend, and wherein the bottom part has a smaller width than the top part of the encapsulant along the lead bearing surfaces of the encapsulant;
trimming off the leads to separate the arrays of semiconductor assemblies from the lead frame;
sawing the semiconductor assemblies from the side of the top parts of the semiconductor assemblies, thereby separating the top parts of the adjacent semiconductor assemblies.

12. A method of manufacturing semiconductor assemblies according to claim 11, wherein after trimming off the leads, the step of forming the leads is carried out.

13. A mould for applying encapsulant over a semiconductor die, comprising a matrix of multiple mould cavities arranged in arrays,
wherein the mould has a top layer of top mould cavities and a bottom layer of bottom mould cavities for encapsulating the leads, and whereby each bottom mould cavity has smaller width, in the direction parallel to the arrays of the mould cavities, than each corresponding top mould cavity, or
wherein the mould has one layer of mould cavities, whereby each bottom side of mould cavity for encapsulating the leads has smaller width, in the direction parallel to the arrays of the mould cavities, than each corresponding top side of mould cavity.
